# EUROPEAN PATENT SPECIFICATION

(11) **EP 4 509 825 B1**
(45) Date of publication and mention of the grant of the patent: **26.11.2025**
(21) Application number: 23191219.7
(22) Date of filing: 12.08.2023
(51) Int. Cl.: G01N 23/2251, H01L 21/66

(54) **A METHOD FOR EVALUATING THE BENDING STIFFNESS OF HIGH ASPECT RATIO NANOSIZED STRUCTURES**
VERFAHREN ZUR BEWERTUNG DER BIEGESTEIFIGKEIT VON NANOSTRUKTUREN MIT HOHEM ASPEKTVERHÄLTNIS
PROCÉDÉ D'ÉVALUATION DE LA RIGIDITÉ À LA FLEXION DE STRUCTURES NANOMÉTRIQUES À RAPPORT D'ASPECT ÉLEVÉ

(43) Date of publication of application: 19.02.2025
(73) Proprietor: IMEC VZW, 3001 Leuven (BE)
(72) Inventor: Xu, XiuMei, 3060 Bertem (BE); Lorusso, Gian Francesco, 3090 Overijse (BE)
(74) Representative: Patent Department IMEC

(56) References cited:
- JP-A- 2012 099 770
- LOPEZ-ROMERO D ET AL: "High aspect-ratio SU-8 resist nano-pillar lattice by e-beam direct writing and its application for liquid trapping", MICROELECTRONIC ENGINEERING, ELSEVIER PUBLISHERS BV., AMSTERDAM, NL, vol. 87, no. 4, 1 April 2010 (2010-04-01), pages 663 - 667, XP026880505, ISSN: 0167-9317, [retrieved on 20090926], DOI: 10.1016/J.MEE.2009.09.007
- SEMINARA ET AL.: "Mechanism of nanostructure movement under an electron beam and its application in patterning", PHYSICAL REVIEW B, vol. 83, 2011, pages 235438, XP002810916

## Description

### Field of the Invention

The present invention is related to semiconductor processing, in particular to the production of high aspect ratio nanometre-sized structures, and to the characterization of mechanical properties of these structures.

### State of the art.

As the miniaturization of structures in semiconductor processing continues, tall and narrow upstanding structures like fins or pillars are being fabricated on a wafer. These structures are referred to as high aspect ratio nanometre-sized structures, hereafter abbreviated as nanosized structures or nanostructures. For example, it is known that pillars are produced having a diameter in the order of a few nanometres up to a few tens of nanometres and a height in the order of 100 nm to 10 µm, i.e. the aspect ratio is higher than 10:1. Similar aspect ratios are obtainable for fin-shaped structures having a width in the order of a few nanometres or tens of nanometres. For such structures, the bending stiffness is an important mechanical property, as it determines the integrity of the structures during the various process steps they go through.

For example, in wet cleaning processes, the surface tension force exerted by the rinsing liquids can often cause the collapse of high aspect ratio nanostructures that are arranged in a regular array. This phenomenon is commonly referred to as pattern collapse. It has been established that there is a correlation between the mechanical stiffness of the structures and the pattern collapse rate, which is a value representative of the number of collapsed structures in a given array.

The determination of the bending stiffness of individual structures is possible by applying destructive methods, such as selectively removing a structure from an array by focused ion beam (FIB), then measure the force and deflection relationship in a Transmission Electron Microscopy (TEM). However, these methods have low throughput, and are not suitable for quickly assessing the mechanical properties of nanostructures produced on a substrate, for example on a process wafer of 300mm in diameter comprising hundreds of semiconductor dies, each die comprising large quantities of high aspect ratio nanostructures arranged in a variety of patterns. Non-destructive methods also exist, for example, a mechanical model can be established using the 3D geometry obtained by scatterometry measurements to calculate the average bending stiffness of the high aspect ratio structures. However, scatterometry measurements demand a large area of approximately 40 µm size with uniform patterning, and in some cases, a mechanical model may not be readily available for structures with complex stacks and geometry.

It is known that the mechanical properties of structures having the same design dimensions can vary significantly across the wafer, as a consequence of a degree of non-uniformity of the lithography and etch techniques applied for producing the structures. It is highly desirable therefore to obtain knowledge of this variation of the mechanical properties without reverting to destructive measurement techniques and without requiring accurate 3D profile measurements of the structures in question. JP2012099770A discloses a method of investigating the collapse rate of nanosized structures.

SEMINARA et al. ("Mechanism of nanostructure movement under an electron beam and its application in patterning",Physical Review B, vol. 83, 2011, page 235438) disclose a method analysis of bending stiffness of nanosized structures and notes that insufficient strength causes collapse of the structures.

### Summary of the invention

The invention is related to methods as disclosed in the appended claims. The invention enables evaluating the bending stiffness of high aspect ratio nanosized structures which are arranged in a plurality of test patterns produced by lithography and etching in a respective plurality of different areas of a semiconductor substrate. Each test pattern comprises at least one regular array of the high aspect ratio structures, i.e. an array formed of mutually identical structures with a constant gap between any pair of adjacent structures in the array, for example a rectangular or hexagonal array. The arrays are characterized by a plurality of parameters, including in-plane dimensions of the structures, their height, the material of the structures and the gap between adjacent structures in the array. With 'in-plane dimensions' is meant dimensions measured in a plane parallel to the plane upon which the structures are standing, for example the diameter of pillar-shaped structures or the width of fin-shaped structures measured at mid-height of the respective structures.

The method includes scanning the arrays in the multiple test patterns by an electron beam produced according to the same set of beam conditions for each pattern, deriving images of the respective arrays by electron beam microscopy, and determining from each of the images an e-beam induced collapse rate, being a value between 0 and 1 representative of the percentage of structures in each array which have collapsed under the influence of said electron beam scanning. The e-beam induced collapse rate is indicative of the bending stiffness of said structures. The term 'indicative' covers various embodiments, for example an embodiment wherein the collapse rate is either 0 or 1, indicating that the stiffness is sufficient to withstand a process that exhibits a similar influence on the test patterns as the e-beam. According to other embodiments, the e-beam is configured to induce a variety of collapse rates (0<collapse rate<1) of the same structures distributed across the substrate or from wafer to wafer. The latter embodiment can be applied for determining the patterning process non-uniformity or variations in terms of the litho and etch process for producing the test patterns. This information can in turn be used to eliminate said non-uniformity from pattern collapse measurements applied to evaluate the uniformity of another process, such as a wet cleaning process. In other embodiments, the e-beam is configured to induce and compare the collapse rates of structures with different geometry (such as different CDs, gaps and heights) or different materials. This enables a comparison of the relative strength of any high aspect ratio structures.

Throughout this specification and in the appended claims, the term 'high aspect ratio nanosized structures' refers to structures characterized by an in-plane critical dimension, for example a diameter or a width, in the order of a few nanometres up to a few tens of nanometres and a height that is significantly higher than said in-plane critical dimension. According to preferred embodiments, the height is at least 3 times higher than said in-plane critical dimension. According to further embodiments, the height is at least 5 times or at least 10 times higher than said in-plane critical dimension.

The invention is in particular related to a method for evaluating the bending stiffness of high aspect ratio nanosized structures arranged in a plurality of test patterns produced by lithography and etching in a respective plurality of different areas of a semiconductor substrate, each test pattern comprising a regular array of said structures, the method comprising the steps of :
- scanning said regular arrays in the multiple test patterns by an electron beam produced according to the same set of beam conditions for each array,
- from the scanning of the arrays, deriving images of said arrays in the respective test patterns by electron beam microscopy,
- determining from each of the images an e-beam induced collapse rate, being a value between 0 and 1 representative of the percentage of structures in each array which have collapsed under the influence of said electron beam scanning, and wherein the e-beam induced collapse rate is indicative of the bending stiffness of said structures.

According to an embodiment, one or more parameters which define said array exhibit a variation between different test patterns as produced in respective different areas of the substrate, and the beam conditions are configured so that said variation leads to a corresponding variation in the collapse rate.

According to an embodiment, said one or more parameters exhibiting a variation are one or more of the following : an in-plane dimension of the structures, the height of the structures, the material of the structures, the gap between adjacent structures in said array.

According to an embodiment, the beam conditions are configured to match the effect in terms of the collapse rate of the structures in the array, of a semiconductor process applicable on the substrate.

According to an embodiment, said arrays in the test patterns are produced on the basis of the same design pattern formed of an array of structures characterized by one or more in-plane design dimensions, and the test patterns are produced by applying the same etch recipe.

According to an embodiment, each test pattern produced respectively in said plurality of areas of the substrate comprises multiple regular arrays produced on the basis of multiple design patterns characterized by respective multiple values of at least one in-plane design dimension and/or of the gap between adjacent structures, wherein said multiple values are distributed across a given range.

According to an embodiment, the collapse rates are recorded in the form of curves expressing the collapse rate as a function of said multiple values in a central, middle and edge area of the substrate.

According to an embodiment, said test patterns are produced using a mask configured to print a device pattern on a plurality of die areas on the substrate, the mask comprising a metrology target included in the field of view of a lithographic tool used for printing the device pattern, and the target is configured to produce the test patterns in the respective die areas.

According to an embodiment, the numerical value of said bending stiffness is derived from the e-beam induced collapse rate, based on a previously determined relation between the collapse rate and the stiffness.

The invention is also related to a method for evaluating a process uniformity of a process that is applicable on a semiconductor substrate, the method comprising the steps of :
- producing a plurality of test patterns by a lithography and etch sequence in a respective plurality of different areas of the substrate, each pattern comprising a regular array of high aspect ratio nanosized structures wherein the arrays are produced on the basis of the same design pattern and wherein the test patterns are produced by applying the same etch recipe, and wherein the lithography and etch sequence exhibits a degree of non-uniformity so that one or more parameters which define said arrays exhibit a variation between different test patterns as produced in respective different areas of the substrate,
- applying a method according the invention on the plurality of arrays, to thereby obtain a plurality of collapse rate measurements for the respective plurality of arrays,
- performing said process on :
   ∘ the substrate wherein said test patterns further comprise at least one duplicate of the array in said respective plurality of different areas, or
   ∘ on another substrate of the same size as the substrate and comprising duplicates of the array in the same plurality of different areas,
- determining the collapse rate induced by the process on images of the respective duplicates of the array,
- using the e-beam induced collapse rates in order to eliminate the effect of said non-uniformity of the lithography and etch sequence from the process-induced collapse rates.
According to an embodiment of the method for evaluating a process uniformity:
- each test pattern comprises multiple regular arrays produced on the basis of multiple design patterns of said arrays characterized by respective multiple values of an in-plane design dimension, wherein said values are distributed across a given range,
- the e-beam induced collapse rates are recorded in the form of curves expressing the collapse rate as a function of said design dimension in a central, middle and edge area of the substrate,
- the process-induced collapse rates are also recorded in the form of curves expressing the collapse rate as a function of said design dimension in said central, middle and edge area of the substrate,
- the process uniformity is evaluated on the basis of whether or not a horizontal shift between the curves corresponding to the centre, middle and edge areas is the same for the process-induced collapse rates as for the e-beam induced collapse rates.
According to embodiments of the method for evaluating a process uniformity, said process is a wet cleaning process or a deposition process.

### Brief description of the figures

Figures 1a and 1b illustrate the capability of scanning an electron beam across a regular pattern of nanosized pillars to induce pattern collapse.
Figures 2a and 2b illustrate the same capability in the case of an array of nanosized fins.
Figure 3 illustrates the result of measurements of the e-beam induced collapse rate of nanosized pillars as a function of the bending stiffness of the pillars.
Figures 4a to 4c illustrate a process wafer provided with printed and etched metrology targets suitable for use in a method according to the invention.
Figures 5a and 5b illustrate a calibration procedure applicable in accordance with an embodiment of the invention.

### Detailed description of the invention

It is known that pattern collapse in a regular array of high aspect ratio nanosized structures can be induced deliberately by scanning the array with an electron beam in a scanning electron microscope. Reference is made for example to document "Mechanism of nanostructure movement under an electron beam and its application in patterning", Seminara et al., Physical Review B 83, 235438 (2011). The beam conditions can be chosen so that at least a portion of the structures in the array are bent or deflected by the interaction with the beam. The image obtained from the microscope reveals the collapsed structures and enables counting them to obtain a value referred to as the collapse rate, which may be expressed as a number between 0 and 1 defined as the ratio of the number of collapsed structures in a given array to the total number of structures in the array.

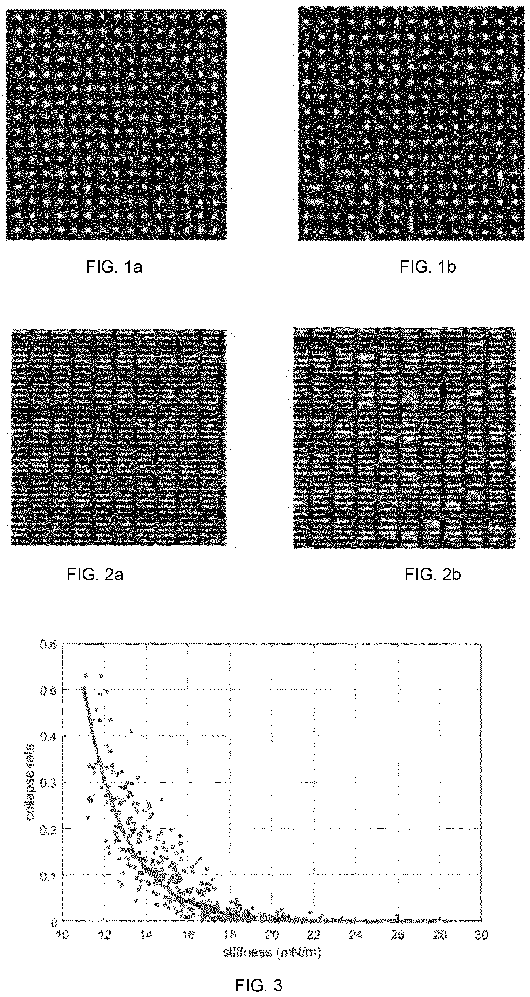

Figures 1a and 1b illustrate an example of a SEM image before and after pattern collapse in an array of nanosized pillars. The first image is obtained by applying an e-beam having insufficient power to cause pattern collapse. Pattern collapse as illustrated in the second image can be induced, for example by raising the beam current and/or the exposure time. As shown in Figures 2a and 2b, the same effect can be obtained in an array of fin-shaped nanosized structures.

This phenomenon of deliberately induced pattern collapse is applied in the method of the invention, in order to quantify differences in the bending stiffness of high aspect ratio nanostructures across a substrate and/or between substrates. Figure 3 illustrates a graph comprising a number of data points, each data point representing the result of measurements performed by the inventors on an array of nanosized pillars similar to the array illustrated in Figure 1a, wherein the average bending stiffness of the pillars in the array varied within a given range. The Y-axis of the graph represents the collapse rate as a consequence of scanning the array by the same e-beam in terms of the e-beam conditions. The X-axis represents the average bending stiffness of the pillars in the arrays. The pillars were modeled using a mechanical model based on a tapered cylindrical profile obtained by scatterometry measurements performed on the arrays. The graph shows that there is a correlation between the e-beam induced collapse rate and the average stiffness of the pillars. Under the same e-beam conditions, higher collapse rates can be observed for structures with lower average bending stiffness.

According to the invention, test patterns formed of high aspect ratio nanosized structures are produced in different areas of a substrate. Each test pattern comprises at least one regular array of said structures. Arrays of the test patterns produced respectively in said areas are scanned by an electron beam produced according to the same set of beam conditions for each scanning. These beam conditions include the following : beam current, exposure time (may also be expressed as number of frames), field of view, landing energy, scanning rate, interlace. The arrays are configured to enable determining an e-beam induced collapse rate between 0 and 1 with a sufficiently high resolution to be able to measure a variation of the collapse rate within said range of 0 to 1. This requires mainly that the number of structures in each array is sufficiently high. The optimal number may differ depending on the shape and dimensions of the structures. Suitable numbers may for example range from about 100 to several hundred, as illustrated in Figures 1 and 2. The arrays may be rectangular arrays as illustrated in Figures 1 and 2, or any other type of regular array, for example an array of structures ordered according to a hexagonal packing arrangement.

From the scanning of the arrays in the different areas of the substrate, images of the arrays are derived by electron beam microscopy, and the collapse rate is determined from each image by counting the number of collapsed structures. The arrays are produced by lithography and etching according to a given set of design dimensions, including the in-plane dimensions of the structures in the array, the height of the structures and the gap between adjacent structures.

According to embodiments of the invention, the test patterns are obtained by printing and etching the same pattern multiple times in different areas across the surface of the substrate, applying the same lithographic and etch conditions in each area, wherein at least one array in each test pattern (i.e. in each area of the substrate) is defined by the same set of design dimensions, including in-plane dimensions and height of the structures.

The repeated test pattern could for example be a large array of the same structures, with a constant gap in between adjacent structures. The dimensions of the array could be in the order of tens of micrometers. This large array thereby comprises multiple duplicates of the same smaller array comprising for example a few hundred structures, so that a collapse rate measurement can be done on a number of said multiple duplicates.

According to another embodiment, the repeated test pattern may include multiple arrays defined by different in-plane design dimensions, for example different design widths of an array of fin-shaped structures, or different gaps between adjacent structures.

According to other embodiments, the test patterns produced in the different areas may differ in terms of the type of structures, their geometry and/or the material of the structures. This could be achieved by applying different lithographic and/or etch conditions in one or more of the different areas, and/or by applying different lithographic masks for producing the different test patterns, and/or by producing one or more of the different test patterns in areas consisting of different materials.

The determination of the collapse rates on one or more arrays within the test patterns enables to evaluate the bending stiffness of the structures included in the test patterns. The term 'evaluate' includes a number of embodiments and is not limited to the actual numerical determination of the bending stiffness. The latter may be possible if the relation between the collapse rate and the stiffness has been previously determined, for example in the form of a curve as shown in Figure 3. In such a case, this curve can be used to derive the stiffness from a measurement of the e-beam induced collapse rates.

However, the method is applicable also when the actual stiffness values are not known, for example if a mechanical model of the structures is not available. One way of applying the method in this way is to verify whether the structures in the test pattern can withstand a particular semiconductor process, for example a wet cleaning step, without actually performing the process. As stated in the introduction, wet cleaning processes can induce pattern collapse in a regular array of high aspect ratio nanosized structures. This may also be the case for other processes. For example certain deposition processes such as flowable CVD (chemical vapour deposition) may also cause pattern collapse,

According to an embodiment, the e-beam conditions are selected to match the effect of a given process on a test pattern comprising an array characterized by a given set of design dimensions. By applying these e-beam conditions to various test patterns distributed across a wafer, it can be verified whether or not these test patterns are able to withstand the corresponding process by evaluating the e-beam induced collapse rates. If the collapse rates are zero across the wafer, the process can be applied. If the collapse rates are higher than zero in at least some areas of the wafer, another process should be selected.

Another application of the method is to assess and compare the relative strength of structures with different geometries. For example, applying the same e-beam conditions to different structures with unknown mechanical properties allows for a rapid assessment of their relative strength compared to a reference structure.

According to other embodiments, the e-beam conditions are selected in order to reveal a variation of the stiffness of the structures across a substrate. It is known that when a regular array of structures characterized by the same in-plane design dimensions is reproduced several times on a wafer, a deviation from one or more of the in-plane design dimensions is inevitable and that this deviation is different in different areas of the substrate. Non-uniform etching could also cause variations in structure heights. This dimensional difference causes a difference in the bending stiffness of the structures, and it is therefore important for designers to be able to quantify this difference.

According to embodiments of the invention therefore, the beam conditions are configured so that the collapse rate of at least one array of the test pattern that is reproduced according to the same design dimensions in different areas of the substrate falls within a suitable range, preferably between 0 and 1, more preferably between 0.2 and 0.8. In other words, suitable e-beam conditions according to these embodiments are determined by the requirement that the beam conditions enable sufficient sensitivity to compare the collapse rate variations for measurements across the wafer or from wafer to wafer.

The electron beam conditions which have an impact on the collapse rate include : beam current, exposure time, field of view, landing energy, scanning rate. Selecting the beam conditions for a given purpose, e.g. to reveal a stiffness variation, or to match the effect of a given process is therefore preferably done by setting or changing one or more of these conditions.

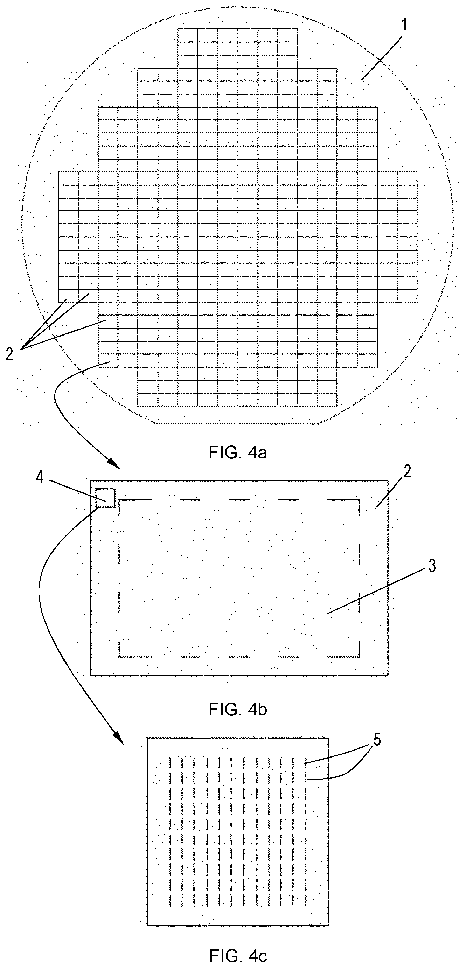

According to embodiments of the invention, the same test pattern is part of a metrology target included in the field of view of a lithographic tool used for producing multiple semiconductor dies on a semiconductor wafer. Figure 4a illustrates a process wafer 1 which may be a silicon wafer as generally known in the art, for example a standard 300mm process wafer. Semiconductor dies 2 are produced on multiple dedicated areas of the wafer. One die area is enlarged and represented in Figure 4b. In a central portion 3 of the die area 2, a given layout of active devices such as transistors and diodes is fabricated by a sequence of process steps including lithography and etch steps configured to produce regular arrays of high aspect ratio nanostructures as described above. It is known to include metrology targets in a lithographic mask designed for the production of such regular arrays. The targets are included in the field of view of the die but outside the active device area 3, for example in the upper left corner of the die area 2, as illustrated in Figure 4.

A metrology target applicable in the method of the invention may include a test pattern in the form of one or more regular arrays of high aspect ratio nanostructures. An example of such a target 4 is illustrated in the enlarged image shown in Figure 4c. The target is designed to produce an array of fins 5 of particular design dimensions, in terms of the width and length of the fins, and the gap between adjacent parallel fins. These dimensions are representative of the dimensions of arrays included in the active area 3 of the die. The critical dimension (CD) of the fins is defined as the width of the fins. In the example shown, the target comprises a single array characterized by a single design CD, but the target could include multiple arrays characterized by the same or different design CDs and possibly different fin lengths and gaps. As stated above, the lithography and etch processes may exhibit a degree of non-uniformity across a wafer, leading to a deviation of the actual CD of the printed and etched structures from the design CD. This in turn leads to a variation in the bending stiffness of the fins.

According to embodiments of the invention, this variation is quantified by scanning the target array 4 in each die area 2 by an electron beam, after producing the array on the wafer by lithography and etching. The beam conditions are chosen so that the beam induces a measurable difference of the collapse rate as a function of a difference in the actual CD across the wafer. The collapse rate is measured on images obtained from scanning the target patterns in a SEM tool.

From the respective images of the target arrays, the collapse rates are determined by counting the number of collapsed fins in each image. The collapse rate may be mapped on the various dies of the wafer, yielding a map that reveals differences in the bending stiffness of structures in the active areas which have the same or similar design CDs and which are arranged in arrays similar to the array included in the target 4.

One useful application of the invention is related to the determination of the process uniformity across a wafer, of semiconductor processing steps performed on said wafer. For example, the effect of wet cleaning steps should be as uniform as possible, i.e. the cleaning action should be the same in every area of the wafer. As stated in the introduction, wet cleaning steps are known to cause pattern collapse, therefore measuring the collapse rate of test patterns formed of high aspect ratio nanosized structures is one way of determining the process uniformity, after the process has been executed on the wafer. However, due to the variation of the dimensions of the structures across the wafer, it is difficult to correctly interpret the collapse rate measurements. The method of the invention provides the possibility of determining this variation before performing the cleaning process, and to thereby determine a baseline correction that is to be applied to the collapse rates induced by said cleaning process. The method of the invention thereby allows to calibrate the wafer in terms of the intrinsic bending stiffness variation, so that the influence of said variation can be eliminated from the collapse rates induced by a processing step. For example, a metrology target could be provided comprising a large micrometre-sized regular array of the same nanosized fins. Within this large array, two smaller arrays of the same size and the same number of structures can be selected. The first of these two smaller arrays could be used to determine the collapse rates by e-beam in accordance with the invention in order to determine the baseline correction for bending stiffness of the structures, while the second of the two smaller arrays can be used to determine the collapse rate induced by the process, for example a wet cleaning process.

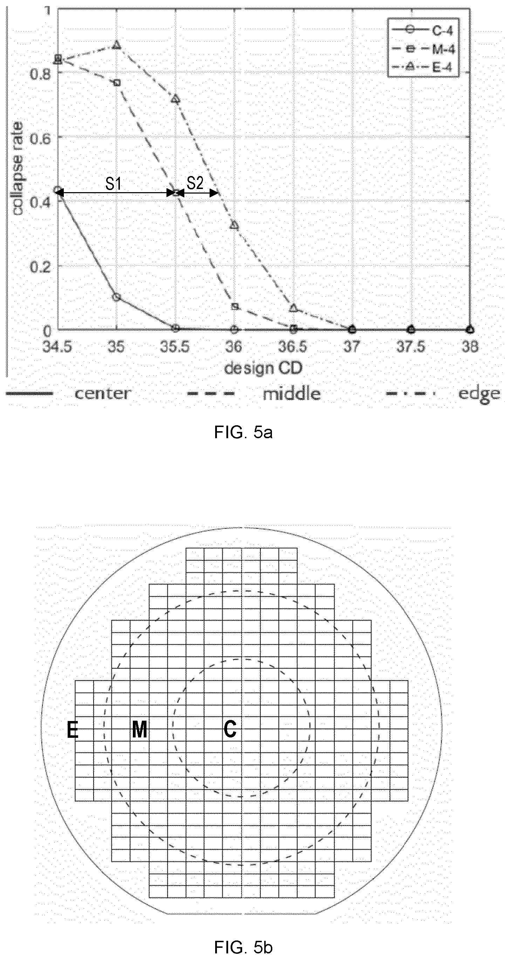

The calibration described in the previous paragraph is based on only one design CD and could therefore provide insufficient information on the process uniformity for other design CD values. An example of a more advanced baseline calibration is illustrated in Figures 5a and 5b. In each die area of a wafer, a plurality of fin arrays is included in the test pattern, characterized by different design CDs distributed regularly across a given range, for example from 34 nm to 38 nm in steps of 0.5 nm. The fin arrays could be included in metrology targets 4 distributed across the wafer as illustrated in Figures 4a to 4c, or a test wafer could be designed comprising only the test patterns in the respective die areas 2. In the latter case, the range of the design CDs could be applied for different fin lengths and/or for different pitches of the array to provide even more variables for which the process uniformity can be evaluated.

Having reproduced the fin arrays in each die area by lithography and etching, the various arrays are imaged by SEM and the collapse rate is measured as a function of the design CD. This is done using e-beam conditions which enable to measure a wide range of collapse rates as a function of the design CDs in at least one area of the wafer.

The result of such a calibration is illustrated in Figure 5a, for the abovenamed range of 34-38nm for the design CD and for a given value of the fin lengths and pitch. The collapse rate is determined in three radially adjacent areas of the wafer, designated as centre, middle and edge, as illustrated in Figure 5b by the abbreviations C, M and E. The graph in Figure 5a shows the relation between the measured e-beam induced collapse rates in the three areas, and the design CDs included in the test arrays. It is seen that for a collapse rate of about 0.45, there are significant shifts S1 and S2 of the curves in the centre and edge areas of the wafer relative to the curve in the middle area of the wafer.

The same curves can be obtained following a wet cleaning step. If the same shifts S1 and S2 are observed after cleaning, the conclusion is that the cleaning process is uniform in the centre, middle and edge areas. Another way of determining the uniformity is by applying the inverse shifts -S1 and -S2 to the edge and centre curves obtained after cleaning, and verifying whether the shifted curves coincide with the middle curve. If this is the case, the process is uniform. Any remaining shifts between the curves indicate a lack of process uniformity.

The calibration procedure described above is performed on a substrate and the result can be used to assess process non-uniformity on said substrate itself, as described. However, the result can also be used on another substrate for assessing the uniformity of the same process on said other substrate. The other substrate is of the same size of the initial substrate and provided with duplicates of the regular array or arrays used in the calibration procedure, and produced in the same areas as the initial substrate.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for evaluating the bending stiffness of high aspect ratio nanosized structures (5) arranged in a plurality of test patterns produced by lithography and etching in a respective plurality of different areas of a semiconductor substrate (1), each test pattern comprising a regular array of said structures (5), the method comprising the steps of :
- scanning said regular arrays in the multiple test patterns by an electron beam produced according to the same set of beam conditions for each array,
- from the scanning of the arrays, deriving images of said arrays in the respective test patterns by electron beam microscopy,
**characterized in that** the method further comprises the step of:
- determining from each of the images an e-beam induced collapse rate, being a value between 0 and 1 representative of the percentage of structures in each array which have collapsed under the influence of said electron beam scanning, and wherein the e-beam induced collapse rate is indicative of the bending stiffness of said structures.

2. The method according to claim 1, wherein one or more parameters which define said array exhibit a variation between different test patterns as produced in respective different areas of the substrate (1), and wherein the beam conditions are configured so that said variation leads to a corresponding variation in the collapse rate.

3. The method according to claim 2, wherein said one or more parameters exhibiting a variation are one or more of the following : an in-plane dimension of the structures (5), the height of the structures (5), the material of the structures, the gap between adjacent structures in said array.

4. The method according to claim 1, wherein the beam conditions are configured to match the effect in terms of the collapse rate of the structures in the array, of a semiconductor process applicable on the substrate (1).

5. The method according to any one of the preceding claims, wherein said arrays in the test patterns are produced on the basis of the same design pattern formed of an array of structures **characterized by** one or more in-plane design dimensions, and wherein the test patterns are produced by applying the same etch recipe.

6. The method according to claim 5, wherein each test pattern produced respectively in said plurality of areas of the substrate (1) comprises multiple regular arrays produced on the basis of multiple design patterns **characterized by** respective multiple values of at least one in-plane design dimension and/or of the gap between adjacent structures, wherein said multiple values are distributed across a given range.

7. The method according to claim 6, wherein the collapse rates are recorded in the form of curves expressing the collapse rate as a function of said multiple values in a central, middle and edge area of the substrate (1).

8. The method according to any one of the preceding claims, wherein said test patterns are produced using a mask configured to print a device pattern on a plurality of die areas (2) on the substrate (1), the mask comprising a metrology target (4) included in the field of view of a lithographic tool used for printing the device pattern, and wherein the target is configured to produce the test patterns in the respective die areas (2).

9. The method according to any one of the preceding claims, wherein the numerical value of said bending stiffness is derived from the e-beam induced collapse rate, based on a previously determined relation between the collapse rate and the stiffness.

10. A method for evaluating a process uniformity of a process that is applicable on a semiconductor substrate (1), the method comprising the steps of :
- producing a plurality of test patterns by a lithography and etch sequence in a respective plurality of different areas of the substrate (1), each pattern comprising a regular array of high aspect ratio nanosized structures (5) wherein the arrays are produced on the basis of the same design pattern and wherein the test patterns are produced by applying the same etch recipe, and wherein the lithography and etch sequence exhibits a degree of non-uniformity so that one or more parameters which define said arrays exhibit a variation between different test patterns as produced in respective different areas of the substrate (1),
- applying the method according to claim 2 on the plurality of arrays, to thereby obtain a plurality of collapse rate measurements for the respective plurality of arrays,
- performing said process on :
∘ the substrate (1) wherein said test patterns further comprise at least one duplicate of the array in said respective plurality of different areas, or
∘ on another substrate of the same size as the substrate and comprising duplicates of the array in the same plurality of different areas,
- determining the collapse rate induced by the process on images of the respective duplicates of the array,
- using the e-beam induced collapse rates in order to eliminate the effect of said non-uniformity of the lithography and etch sequence from the process-induced collapse rates.

11. The method according to claim 10, wherein :
- each test pattern comprises multiple regular arrays produced on the basis of multiple design patterns of said arrays **characterized by** respective multiple values of an in-plane design dimension, wherein said values are distributed across a given range,
- the e-beam induced collapse rates are recorded in the form of curves expressing the collapse rate as a function of said design dimension in a central, middle and edge area of the substrate,
- the process-induced collapse rates are also recorded in the form of curves expressing the collapse rate as a function of said design dimension in said central, middle and edge area of the substrate,
- the process uniformity is evaluated on the basis of whether or not a horizontal shift between the curves corresponding to the centre, middle and edge areas is the same for the process-induced collapse rates as for the e-beam induced collapse rates.

12. The method according to claim 10 or 11, wherein said process is a wet cleaning process or a deposition process.

## Patentansprüche

1. Verfahren zum Bewerten der Biegesteifigkeit von nanoskaligen Strukturen (5) mit hohem Seitenverhältnis, die in einer Vielzahl von Testmustern angeordnet sind, die durch Lithographie und Ätzen in einer jeweiligen Vielzahl von unterschiedlichen Bereichen eines Halbleitersubstrats (1) erzeugt werden, wobei jedes Testmuster ein regelmäßiges Array der Strukturen (5) umfasst, wobei das Verfahren die folgenden Schritte umfasst:
- Abtasten der regelmäßigen Arrays in den mehreren Testmustern durch einen Elektronenstrahl, der gemäß dem gleichen Satz von Strahlbedingungen für jedes Array erzeugt wird,
- aus der Abtastung der Arrays, Ableiten von Bildern der Arrays in den jeweiligen Testmustern durch Elektronenstrahlmikroskopie,
**dadurch gekennzeichnet, dass** das Verfahren weiter den Schritt umfasst:
- Bestimmen aus jedem der Bilder einer Elektronenstrahl-induzierten Kollapsrate, wobei ein Wert zwischen 0 und 1 den Prozentsatz der Strukturen in jedem Array darstellt, die unter dem Einfluss der Elektronenstrahlabtastung kollabiert sind, und wobei die Elektronenstrahl-induzierte Kollapsrate die Biegesteifigkeit der Strukturen angibt.

2. Verfahren nach Anspruch 1, wobei ein oder mehrere Parameter, die das Array definieren, eine Variation zwischen unterschiedlichen Testmustern aufweisen, wie sie in jeweiligen unterschiedlichen Bereichen des Substrats (1) erzeugt werden, und wobei die Strahlbedingungen derart konfiguriert sind, dass die Variation zu einer entsprechenden Variation der Kollapsrate führt.

3. Verfahren nach Anspruch 2, wobei der eine oder die mehreren Parameter, die eine Variation aufweisen, eines oder mehrere der Folgenden sind: eine Ebenen Dimension der Strukturen (5), die Höhe der Strukturen (5), das Material der Strukturen, der Spalt zwischen angrenzenden Strukturen in dem Array.

4. Verfahren nach Anspruch 1, wobei die Strahlbedingungen dazu konfiguriert sind, dem Effekt eines auf dem Substrat (1) anwendbaren Halbleiterprozesses hinsichtlich der Kollapsrate der Strukturen in dem Array zu entsprechen.

5. Verfahren nach einem der vorstehenden Ansprüche, wobei die Arrays in den Testmustern auf der Grundlage desselben Entwurfsmusters erzeugt werden, das aus einem Array von Strukturen gebildet ist, die durch eine oder mehrere Entwurfsabmessungen in der Ebene gekennzeichnet sind, und wobei die Testmuster durch Anwenden derselben Ätzrezeptur erzeugt werden.

6. Verfahren nach Anspruch 5, wobei jedes Testmuster, das jeweils in der Vielzahl von Bereichen des Substrats (1) erzeugt wird, mehrere regelmäßige Arrays umfasst, die auf der Grundlage mehrerer Entwurfsmuster erzeugt werden, die durch jeweilige mehrere Werte von mindestens einer Entwurfsabmessung in der Ebene und/oder den Spalt zwischen benachbarten Strukturen gekennzeichnet sind, wobei die mehreren Werte über einen bestimmten Bereich verteilt sind.

7. Verfahren nach Anspruch 6, wobei die Kollapsraten in Form von Kurven aufgezeichnet werden, die die Kollapsrate als eine Funktion der mehreren Werte in einem zentralen, mittleren und Randbereich des Substrats (1) ausdrücken.

8. Verfahren nach einem der vorstehenden Ansprüche, wobei die Testmuster unter Verwendung einer Maske erzeugt werden, die zum Drucken eines Vorrichtungsmusters auf einer Vielzahl von Chipbereichen (2) auf dem Substrat (1) konfiguriert ist, wobei die Maske ein Messziel (4) umfasst, das in dem Sichtfeld eines zum Drucken des Vorrichtungsmusters verwendeten lithografischen Werkzeugs beinhaltet ist, und wobei das Ziel zum Erzeugen der Testmuster in den jeweiligen Chipbereichen (2) konfiguriert ist.

9. Verfahren nach einem der vorstehenden Ansprüche, wobei der numerische Wert der Biegesteifigkeit aus der durch den Elektronenstrahl induzierten Kollapsrate auf der Grundlage einer zuvor bestimmten Beziehung zwischen der Kollapsrate und der Steifigkeit abgeleitet wird.

10. Verfahren zum Bewerten einer Prozessgleichmäßigkeit eines Prozesses, der auf einem Halbleitersubstrat (1) anwendbar ist, wobei das Verfahren die folgenden Schritte umfasst:
- Erzeugen einer Vielzahl von Testmustern durch eine Lithographie- und Ätzsequenz in einer jeweiligen Vielzahl von unterschiedlichen Bereichen des Substrats (1), wobei jedes Muster ein regelmäßiges Array aus nanoskaligen Strukturen (5) mit hohem Seitenverhältnis umfasst, wobei die Arrays auf der Grundlage desselben Entwurfsmusters erzeugt werden, und wobei die Testmuster durch Anwenden derselben Ätzrezeptur erzeugt werden, und wobei die Lithographie- und Ätzsequenz einen Grad an Ungleichmäßigkeit derart aufweist, dass ein oder mehrere Parameter, die die Arrays definieren, eine Variation zwischen unterschiedlichen Testmustern, wie sie in den jeweiligen unterschiedlichen Bereichen des Substrats (1) erzeugt werden, aufweisen,
- Anwenden des Verfahrens nach Anspruch 2 auf die Vielzahl von Arrays, um dadurch eine Vielzahl von Kollapsratenmessungen für die jeweilige Vielzahl von Arrays zu erlangen,
- Ausführen des Prozesses auf:
- dem Substrat (1), wobei die Testmuster weiter mindestens ein Duplikat des Arrays in der jeweiligen Vielzahl unterschiedlicher Bereiche umfassen, oder
- auf einem anderen Substrat mit der gleichen Größe wie das Substrat und Duplikate des Arrays in der gleichen Vielzahl unterschiedlicher Bereiche umfassend,
- Bestimmen der durch den Prozess induzierten Kollapsrate auf Bildern der jeweiligen Duplikate des Arrays,
- unter Verwendung der Elektronenstrahl-induzierten Kollapsraten, um den Effekt der Ungleichmäßigkeit der Lithographie- und Ätzsequenz aus den prozessinduzierten Kollapsraten zu eliminieren.

11. Verfahren nach Anspruch 10, wobei:
- jedes Testmuster mehrere regelmäßige Arrays umfasst, die auf der Grundlage mehrerer Entwurfsmuster der Arrays erzeugt werden, die durch jeweilige mehrere Werte einer Entwurfsabmessung in der Ebene gekennzeichnet sind, wobei die Werte über einen gegebenen Bereich verteilt sind,
- die Elektronenstrahl-induzierten Kollapsraten in der Form von Kurven aufgezeichnet werden, die die Kollapsrate als eine Funktion der Entwurfsabmessung in einem zentralen, mittleren und Randbereich des Substrats ausdrücken,
- die prozessbedingten Kollapsraten auch in Form von Kurven aufgezeichnet werden, die die Kollapsrate als eine Funktion der Entwurfsabmessung in dem zentralen, mittleren und Randbereich des Substrats ausdrücken,
- die Prozessgleichmäßigkeit auf der Grundlage davon bewertet wird, ob eine horizontale Verschiebung zwischen den Kurven, die dem zentralen, mittleren und Randbereich entsprechen, für die prozessbedingten Kollapsraten dieselbe ist wie für die Elektronenstrahl-induzierten Kollapsraten.

12. Verfahren nach Anspruch 10 oder 11, wobei der Prozess ein Nassreinigungsprozess oder ein Abscheidungsprozess ist.

## Revendications

1. Procédé d'évaluation de la rigidité à la flexion de structures nanométriques à rapport d'aspect élevé (5) disposées selon une pluralité de motifs de test produits par lithographie et gravure dans une pluralité respective de zones différentes d'un substrat semi-conducteur (1), chaque motif de test comprenant un réseau régulier desdites structures (5), le procédé comprenant les étapes suivantes :
- le balayage desdits réseaux réguliers dans les multiples motifs de test par un faisceau d'électrons produit selon le même ensemble de conditions de faisceau pour chaque réseau,
- à partir du balayage des réseaux, la dérivation d'images desdits réseaux dans les motifs de test respectifs par microscopie à faisceau d'électrons,
**caractérisé en ce que** le procédé comprend en outre les étapes suivantes :
- la détermination, à partir de chacune des images, d'un taux d'effondrement induit par faisceau d'électrons, qui est une valeur comprise entre 0 et 1 représentative du pourcentage de structures dans chaque réseau qui se sont effondrées sous l'influence dudit balayage par faisceau d'électrons, et dans lequel le taux d'effondrement induit par faisceau d'électrons est indicatif de la rigidité à la flexion desdites structures.

2. Procédé selon la revendication 1, dans lequel un ou plusieurs paramètres qui définissent ledit réseau présentent une variation entre différents motifs de test tels que produits dans différentes zones respectives du substrat (1), et dans lequel les conditions de faisceau sont configurées de telle sorte que ladite variation conduit à une variation correspondante du taux d'effondrement.

3. Procédé selon la revendication 2, dans lequel lesdits un ou plusieurs paramètres présentant une variation sont un ou plusieurs des éléments suivants : une dimension dans le plan des structures (5), la hauteur des structures (5), le matériau des structures, l'espace entre des structures adjacentes dans ledit réseau.

4. Procédé selon la revendication 1, dans lequel les conditions de faisceau sont configurées pour correspondre à l'effet en termes du taux d'effondrement des structures dans le réseau, d'un processus semi-conducteur applicable sur le substrat (1).

5. Procédé selon l'une quelconque des revendications précédentes, dans lequel lesdits réseaux dans les motifs de test sont produits sur la base du même motif de conception formé d'un réseau de structures **caractérisé par** une ou plusieurs dimensions de conception dans le plan, et dans lequel les motifs de test sont produits en appliquant la même recette de gravure.

6. Procédé selon la revendication 5, dans lequel chaque motif de test produit respectivement dans ladite pluralité de zones du substrat (1) comprend de multiples réseaux réguliers produits sur la base de multiples motifs de conception **caractérisés par** de multiples valeurs respectives d'au moins une dimension de conception dans le plan et/ou de l'espace entre des structures adjacentes, dans lequel lesdites multiples valeurs sont réparties sur une plage donnée.

7. Procédé selon la revendication 6, dans lequel les taux d'effondrement sont enregistrés sous la forme de courbes exprimant le taux d'effondrement en fonction desdites multiples valeurs dans une zone centrale, médiane et de bord du substrat (1).

8. Procédé selon l'une quelconque des revendications précédentes, dans lequel lesdits motifs de test sont produits à l'aide d'un masque configuré pour imprimer un motif de dispositif sur une pluralité de zones de matrice (2) sur le substrat (1), le masque comprenant une cible de métrologie (4) incluse dans le champ de vision d'un outil lithographique utilisé pour imprimer le motif de dispositif, et dans lequel la cible est configurée pour produire les motifs de test dans les zones de matrice respectives (2).

9. Procédé selon l'une quelconque des revendications précédentes, dans lequel la valeur numérique de ladite rigidité à la flexion est dérivée du taux d'effondrement induit par faisceau d'électrons, sur la base d'une relation préalablement déterminée entre le taux d'effondrement et la rigidité.

10. Procédé d'évaluation d'une uniformité de processus d'un processus qui est applicable sur un substrat semi-conducteur (1), le procédé comprenant les étapes suivantes :
- la production d'une pluralité de motifs de test par une séquence de lithographie et de gravure dans une pluralité respective de zones différentes du substrat (1), chaque motif comprenant un réseau régulier de structures nanométriques à rapport d'aspect élevé (5), dans lequel les réseaux sont produits sur la base du même motif de conception et dans lequel les motifs de test sont produits en appliquant la même recette de gravure, et dans lequel la séquence de lithographie et de gravure présente un degré de non-uniformité tel qu'un ou plusieurs paramètres qui définissent lesdits réseaux présentent une variation entre différents motifs de test tels que produits dans différentes zones respectives du substrat (1),
- l'application du procédé selon la revendication 2 sur la pluralité de réseaux, pour obtenir ainsi une pluralité de mesures de taux d'effondrement pour la pluralité respective de réseaux,
- l'exécution dudit processus sur :
- le substrat (1) dans lequel lesdits motifs de test comprennent en outre au moins un double du réseau dans ladite pluralité respective de zones différentes, ou
- sur un autre substrat de la même taille que le substrat et comprenant des doubles du réseau dans la même pluralité de zones différentes,
- la détermination du taux d'effondrement induit par le processus sur des images des doubles respectifs du tableau,
- l'utilisation des taux d'effondrement induits par faisceau d'électrons afin d'éliminer l'effet de ladite non-uniformité de la séquence de lithographie et de gravure par rapport aux taux d'effondrement induits par processus.

11. Procédé selon la revendication 10, dans lequel :
- chaque motif de test comprend de multiples réseaux réguliers produits sur la base de multiples motifs de conception desdits réseaux **caractérisés par** de multiples valeurs respectives d'une dimension de conception dans le plan, dans lequel lesdites valeurs sont réparties sur une plage donnée,
- les taux d'effondrement induits par faisceau d'électrons sont enregistrés sous la forme de courbes exprimant le taux d'effondrement en fonction de ladite dimension de conception dans une zone centrale, médiane et de bord du substrat,
- les taux d'effondrement induits par processus sont également enregistrés sous la forme de courbes exprimant le taux d'effondrement en fonction de ladite dimension de conception dans ladite zone centrale, médiane et de bord du substrat,
- l'uniformité du processus est évaluée sur la base de la condition si un décalage horizontal entre les courbes correspondant aux zones centrale, médiane et de bord est ou non le même pour les taux d'effondrement induits par processus que pour les taux d'effondrement induits par faisceau d'électrons.

12. Procédé selon la revendication 10 ou 11, dans lequel ledit procédé est un processus de nettoyage humide ou un processus de dépôt.
